# EUROPÄISCHE PATENTANMELDUNG

(11) **EP 3 461 241 A1**
(43) Veröffentlichungstag der Anmeldung: **27.03.2019**
(21) Anmeldenummer: 17192840.1
(22) Anmeldetag: 25.09.2017
(51) Int. Cl.: H05K 1/02, H05K 1/11, H05K 1/18, H05K 3/46, H05K 3/34, H05K 3/36, H05K 3/40

(54) **ELEKTRISCHE SCHALTVORRICHTUNG**

(71) Anmelder: Delphi Technologies, Inc., Troy, MI 48007-5052 (US)
(72) Erfinder: SOVVA, Valerij, 40223 DÜSSELDORF (DE); SCHEUMANN, Uwe, 42929 WERMELSKIRCHEN (DE); SYCHA, Michael, 42285 WUPPERTAL (DE)
(74) Vertreter: Robert, Vincent

(57) **Zusammenfassung**

Schaltvorrichtung (10) zum Schalten von elektrischen Strömen, umfassend eine Leiterplatte (40) aufweisen eine erste leitfähig beschichtete Fläche (44) und eine zweite leitfähig beschichtete Fläche (46), angeordnet auf einer ersten Oberfläche (42) der Leiterplatte (40), wobei die erste leitfähig beschichtete Fläche (44) von einer nicht leitfähigen dritten Fläche (48) umrandet ist und wobei die dritte Fläche (48) von der zweiten leitfähig beschichteten Fläche (46) umgeben ist, und mindestens drei Halbleiterbauelementen (20), wobei jedes Halbleiterbauelement (20) einen Körper (22), mit mindestens einem ersten Kontaktelement (24) und einem zweiten Kontaktelement (26) aufweist, wobei die Halbleiterelemente (20) auf der Leiterplatte angeordnet sind, und wobei die ersten Kontaktelemente (24) mit der ersten leitfähig beschichteten Fläche (44) elektrisch verbunden sind und wobei die zweiten Kontaktelemente (24) mit der zweiten leitfähig beschichteten Fläche (46) elektrisch verbunden sind, wobei die Halbleiterbauelemente (20) gleichmäßig verteilt, entlang des Umfangs, der ersten leitfähig beschichteten Fläche (44) angeordnet sind.

## Beschreibung

Die Erfindung betrifft eine elektrische Schaltvorrichtung, zum Schalten von großen elektrischen Strömen. Insbesondere zum Schalten von Strömen bei elektrisch angetriebenen Fahrzeugen.

### TECHNISCHER HINTERGRUND DER ERFINDUNG

Bei modernen Kraftfahrzeugen, insbesondere Elektrofahrzeugen, sind zum Betrieb der Fahrzeuge große elektrische Ströme notwendig. Diese großen Ströme werden im Kabelsatz des Fahrzeugs durch elektrische Leitungen mit großen Querschnitten geführt. Gesteuert werden die Ströme von computergestützten Steuereinheiten. Diese Steuereinheiten umfassen Leiterplatten auf denen elektrische und elektronische Bauteile platziert sind, die unter anderem auch diese hohen Ströme steuern. Da Leiterplatten normalerweise verhältnismäßig dünne leitfähige Beschichtungen aufweisen, sind sie nicht zum Leiten von Strömen im Bereich einiger hundert Ampere geeignet. Um die hohen Ströme, mit vertretbaren Spannungsverlusten über die Leiterplatten fließen zu lassen, müssten die leitfähigen Beschichtungen deutlich größere Schichtdicken aufweisen. Diese größeren Schichtdicken würden die Kosten bei der Produktion der Leiterplatten deutlich erhöhen. Trotz größerer Schichtdicken würden sich die Leiterbahnen spürbar erwärmen, da die Breite der Leiterbahnen nicht unendlich vergrößert werden kann. Somit würde auch das Innere der Steuereinheiten zusätzlich erwärmt. Eine Lösung für dieses Problem ist der Einsatz von gestanzten Blechen, die mit den Leiterplatten elektrisch verbunden sind und die hohen Ströme von und zu den Schaltelementen leiten, um die Leiterbahnen zu entlasten. Diese Bleche sind in der Technik unter dem Begriff Stromschiene oder "bus bar" bekannt. Allerdings bedeutet die Verwendung dieser Stromschienen zusätzlichen Aufwand bei der Herstellung und Montage. Die Stromschienen müssen hergestellt und bei der Montage bereitgestellt werden. Des Weiteren muss Raum für die Stromschienen in den Gehäusen der Steuereinheiten vorgesehen werden, was die Gehäuse zwingend größer macht. Diese Anforderungen lassen die Kosten und das Gewicht des Endprodukts steigen.

Der Erfindung liegt die Aufgabe zu Grunde eine Schaltvorrichtung zum Schalten von hohen elektrischen Strömen bereitzustellen, die die Nachteile des Stands der Technik vermeidet und eine kostengünstige Schaltverrichtung bereitzustellen, die mit verringertem Fertigungsaufwand herzustellen ist und gleichzeitig kleinere Baumasse und des Weiteren wenig wärme produziert.

### BESCHREIBUNG DER ERFINDUNG

Die Aufgabe wird durch eine Schaltvorrichtung nach Anspruch 1 gelöst.

Insbesondere durch eine Schaltvorrichtung zum Schalten von elektrischen Strömen, umfassend eine Leiterplatte aufweisen eine erste leitfähig beschichtete Fläche und eine zweite leitfähig beschichtete Fläche, angeordnet auf einer ersten Oberfläche der Leiterplatte. Die erste leitfähig beschichtete Fläche ist von einer nicht leitfähigen dritten Fläche umrandet. Die dritte Fläche ist von der zweiten leitfähig beschichteten Fläche umgeben. Mindestens drei Halbleiterbauelementen sind auf der Leiterplatte angeordnet, wobei jedes Halbleiterbauelement einen Körper, mit mindestens einem ersten Kontaktelement und einem zweiten Kontaktelement aufweist. Die ersten Kontaktelemente sind mit der ersten leitfähig beschichteten Fläche elektrisch verbunden und die zweiten Kontaktelemente sind mit der zweiten leitfähig beschichteten Fläche elektrisch verbunden. Die Halbleiterbauelemente sind entlang des Umfangs, der ersten leitfähig beschichteten Fläche gleichmäßig verteilt, angeordnet.

Bei der erfinderischen Schaltvorrichtung werden die Halbleiterbauelemente (Stromschalter) so angeordnet, dass der Strom, der zum den zweiten Kontaktelementen der Halbleiterbauelemente fliest, gleichmäßig über eine große leitfähige Fläche der Leiterplatte geführt wird. Durch die große Fläche der leitfähigen Beschichtung ergeben sich verhältnismäßig kleine elektrische Übergangswiderstände, sowie kleine Stromdichten in der leitfähigen Beschichtung. Dieses reduziert die Wärmeentwicklung innerhalb der Steuereinheiten. Durch Anordnung der Halbleiterbauelemente in der Art, dass sie einen gewissen Abstand zueinander haben, wird erreicht, dass sich der Strom gleichmäßig auf die Halbleiterbauelemente verteilen kann. Dadurch wird die vorhandene zweite leitfähige Fläche optimal zur Stromleitung genutzt. Für den Strom der aus den ersten Kontaktelementen, aus den Halbleiterbauelementen (Schaltern) heraus fließt, steht nur noch eine sehr begrenzte Menge an erster leitfähiger Beschichtung zur Verfügung. Deshalb werden die Halbleiterbauelemente um einen kleinen Bereich der leitfähigen Beschichtung herum angeordnet, so dass die ersten Kontaktelemente relativ dicht beieinander sind. Des Weiteren wird eine gute Kontaktierungsmöglichkeit für ein massives Kontaktelement auf dem kleinen Bereich der leitfähigen Beschichtung vorgesehen. Das massive Kontaktelement kann als massiver Kontaktstift ausgeführt sein. Die ersten Kontaktelemente sind somit sehr nah an dem massiven Kontaktelement angeordnet und elektrisch mit der ersten leitfähigen Beschichtung verbunden. Das massive Kontaktelement mit dem die Schaltvorrichtung verbunden werden kann, kontaktiert den kleinen Bereich der ersten leitfähigen Beschichtung sehr nah an den ersten Kontaktelementen des Halbleiterbauelements.

Somit ist die Strecke zwischen den ersten Kontaktelementen und dem massiven Kontaktelement sehr klein, oder alternativ ausgedrückt, die Strecke die der Strom über die leitfähige Beschichtung zurücklegt, ist sehr kurz. Durch die kleine Fläche der ersten leitfähigen Beschichtung ergeben sich verhältnismäßig große elektrische Übergangswiderstände, sowie große Stromdichten in der leitfähigen Beschichtung. Jedoch wirken sich diese Effekte nicht stark aus, da die Strecke, die der Strom durch die leitfähige Fläche zurücklegen muss, relativ kurz ist. In der Praxis beträgt dieser Strecke zwischen Bruchteilen von Millimetern und wenigen Millimetern. Die Anordnung der Halbleiterbauelemente ermöglicht auch hier eine gleichmäßige Stromverteilung über die kleinere erste leitfähige Fläche. In der Praxis habe sich z.B. N-Kanal MOSFETs der Bezeichnung AUIRFS8409-7P als Halbleiterschalter bewährt.

Bevorzugt weist die ersten leitfähig beschichteten Fläche einen kreisförmigen Umfang auf und die Halbleiterbauelemente sind kreisförmig um die erste leitfähig beschichtete Fläche angeordnet. Die Halbleiterbauelemente sind gleichmäßig über den Umfang verteilt. Die erste leitfähig beschichtete Fläche ist scheibenförmig ausgebildet und wird vorzugsweise im Zentrum der Leiterplatte angeordnet, um die zweite leitfähige Beschichtung großflächig, um das Zentrum herum, anordnen zu können. Bei einem kreisförmigen Umfang ist es besonders einfach die Positionen der Halbleiterbauelemente zu bestimmen. Der Umfang muss einfach durch die Anzahl der Halbleiterbauelemente geteilt werden. Das Ergebnis sind Winkel (bezogen auf das Zentrum der ersten leitfähig beschichteten Fläche) an denen die Halbleiterbauelemente entlang des Umfanges positioniert werden müssen. Bei Einsatz von vier Halbleiterbauelemente würde sich ein Winkel von 90° ergeben. Die Halbleiterbauelemente würden somit in einem einen Winkelabstand von 90° angeordnet werden. Es ist auch denkbar die Halbleiterbauelemente entlang zweier voneinander beabstandeter Kreise anzuordnen. Dabei umgibt der zweite kreis den ersten kreis konzentrisch.

Bevorzugt weist die Leiterplatte im Zentrum der ersten leitfähig beschichteten Fläche eine Anschlussöffnung, zum Durchführen eines Kontaktstiftes auf, wobei der Durchmesser der Anschlussöffnung kleiner ist als der Durchmesser der ersten leitfähig beschichteten Fläche. Der Kontaktstift kann durch eine Schraubenverbindung (oder Nieten) mit der ersten leitfähig beschichteten Fläche verbunden werden. Zu diesem Zweck kann eine Anschlussöffnung im Zentrum der ersten leitfähig beschichteten Fläche vorgesehen werden, durch die ein Kontaktstift gesteckt werden kann. Der Kontaktstift kann mit einem Schraubengewinde versehen sein und mittels Unterlegscheiben und einer Mutter an der Leiterplatte befestigt werden. Wobei der Kontaktstift sowie Unterlegscheiben und Mutter vorzugsweise aus Kupfer bestehen sollten, um eine gute Strom und Wärmeleitung zu gewährleisten. Der Kontaktstift kann zum Beispiel auch aufgelötet werden oder per leitfähigen Kleber elektrisch kontaktiert und mechanisch verbunden werden. Die erste leitfähig beschichtete Fläche wird üblicherweise durch Löten mit den ersten Kontaktelementen elektrisch verbunden.

Besonders bevorzugt ist die erste leitfähig beschichtete Fläche wesentlich kleiner als die zweite leitfähig beschichtete Fläche. Die zweite leitfähig beschichtete Fläche muss wesentlich größer sein weil die Strecke, die der Strom zurücklegen muss, länger ist. Über eine große Fläche kann sich der Strom besser verteilen und die stromdichten werden geringer. Das führt zu einer geringeren Wärmentwicklung, was sowohl technisch und auch ökologisch erwünscht ist.

Bevorzugt ist die nicht leitfähige dritte Fläche frei von leitfähiger Beschichtung. Die nicht leitfähige dritte Fläche bildet einen Isolationsbereich zwischen der ersten leitfähigen Fläche und der zweiten leitfähigen Fläche. Üblicherweise wird die leitfähige Beschichtung der Leiterplatte in diesem Bereich durch ätzen oder Fräsen entfernt, so das nur das isolierende Leiterplattensubstrat übrigbleibt.

Bevorzugt weist die Leiterplatte eine innere leitfähige Schicht auf, die zwischen den Oberflächen der Leiterplatte verläuft. Die Halbleiterbauelemente weisen ein drittes Kontaktelement auf. Das dritte Kontaktelement ist elektrisch mit der, innerhalb verlaufenden, inneren leitfähigen Schicht verbunden. Um die Halbleiterbauelemente (Schalter) elektrisch ansteuerbar zu machen, kann bei Multi Layer Leiterplatten eine innere leitfähige Schicht zur Steuerung der Halbleiterbauelemente vorgesehen werden. Das dritte Kontaktelement des Halbleiterbauelements kann dann mit dieser inneren leitfähigen Schicht elektrisch verbunden werden. Möchte man keine Multi Layer Leiterplatten benutzen, dann müssen die Halbleiterbauelemente auf andere Art und Weise angesteuert werden. Möglichkeiten dieses zu tun finden sich zu genüge im Stand der Technik.

Besonders bevorzugt weist die Leiterplatte im Bereich der ersten leitfähig beschichteten Fläche eine Öffnung, zum Durchführen eines Kontaktstiftes auf. Die zweite leitfähig beschichtete Fläche kann ebenfalls über einen Kontaktstift mit einer elektrischen Leitung, elektrisch verbunden werden. Zu diesem Zweck weist die zweite beschichtete Fläche eine Öffnung auf, durch die ein Kontaktstift geführt werden kann und elektrisch sowie mechanisch (wie oben bereits beschrieben) mit der Leiterplatte verbunden werden kann. Bevorzugt können auch mehrere Öffnungen und Kontaktstifte vorgesehen werden um mehrere, Strom ein oder Austritts Punkte zu generieren. Diese Ausführungsart eignet sich besonders, wenn die Leiterplatte direkt an die Kontaktstifte eines elektrischen Gerätes (elektrischer Motor, Inverter) angebracht werden soll. Daraus ergibt sich ein sehr kompaktes Design mit wenig Platzbedarf. Natürlich ist es möglich die zweite leitfähige Beschichtung mittels eines, an die leitfähige Beschichtung gelötetes oder geklemmtes, Kontaktelement zu kontaktieren.

Bevorzugt weist die Leiterplatte eine Vielzahl von leitfähigen Schichten auf, die innerhalb des Leiterplatten-Substrats verlaufen, wobei ein erster Teil der Schichten mittels einer Vielzahl von Durchkontaktierungen mit der erste leitfähig beschichtete Fläche verbunden ist und wobei ein zweiter Teil der Schichten mittels einer Vielzahl von Durchkontaktierungen mit der zweiten leitfähig beschichteten Fläche verbunden ist. Dieser Aufbau senkt den Gesamtwiderstand des Strompfades.

Bevorzugt ist der Aufbau und die Bestückung der Leiterplatte auf einer zweiten Oberfläche, gegenüber der ersten Oberfläche, identisch zur ersten Oberfläche gestaltet. Der Aufbau der ersten Oberfläche ist identisch mit dem Aufbau auf der Rückseite der Leiterplatte. Die Halbleiterbaudelemente auf beiden Oberflächen sind nur von der Leiterplatte getrennt. Durch diesen Aufbau lässt sich der schaltbare Strom mit nur einer Leiterplatte verdoppeln und die Produktionskosten verringern.

Bevorzugt sind die zweite leitfähig beschichtete Fläche auf der zweiten Oberfläche und die zweiten leitfähig beschichteten Fläche auf der ersten Oberfläche in einem Winkel, in Bezug zur Anschlussöffnung, angeordnet.
Durch einen Winkelversatz können die Halbleiterbauelemente auf beiden Oberflächen so angeordnet werden, das sie sich nicht (durch die Leiterplatte hindurch) gegenseitig erwärmen. Die Größe des Winkelversatzes ergibt sich aus der Anzahl verwendeter Halbleiterbauelemente.

Bevorzugt ist das ersten Kontaktelement der Halbleiterbauelemente als, aus dem Körper ragendes, Bein ausgeführt. Das zweiten Kontaktelement wird durch eine leitende Fläche des Körpers, der Halbleiterbauelemente gebildet. Das zweite Kontaktelement wird an seiner leitenden Fläche mit der zweiten leitfähig beschichteten Fläche der Leiterplatte elektrisch verbunden. Dadurch wird eine großflächige Kontaktierung mit niedrigem übergangswiderstand möglich. Der Halbleiter -Chip ist innerhalb des Halbleiterbauelements relativ nahe am zweiten Kontaktelement angeordnet. Dadurch kann die, im Halbleiter -Chip entstehende, Wärme optimal über die leitende Fläche des Körpers in die große, zweite, leitfähig beschichtete, Fläche der Leiterplatte geführt werden. Gebräuchliche Halbleiterbauelemente für Hochstromanwendungen verwenden die genannte Bauart. Es können also Standard Halbleiterbauelemente benutzt werden. Dieses reduziert die Kosten der Schaltvorrichtung.

Bevorzugt sind sechs Halbleiterbauelementen gleichmäßig, entlang des Umfangs der ersten leitfähig beschichteten Fläche, angeordnet. Die Verwendung von sechs Halbleiterbauelemente hat sich in der Praxis als besonders effektiv erwiesen. Da mit herkömmlichen Halbleiterbauelemente die technischen Anforderungen unter Berücksichtigung der Baugröße, thermischem Verhalten und Kosten erfüllt werden können.

Bevorzugt ist ein Schaltmodul umfassend eine Vielzahl von Schaltvorrichtung, wobei die Schaltvorrichtungen durch Kontaktstifte miteinander verbunden sind. Der Einsatz von mehreren Schaltvorrichtung die durch massive Kontaktstifte miteinander verbunden sind erlaubt Schaltströme von vielen hundert Ampere. Die Schaltmodule können sehr kompakt aufgebaut und preiswert hergestellt werden.
Bevorzugt ist ein Fahrzeug mit einer erfinderischen Schaltvorrichtung ausgestattet.

### KURZBESCHREIBUNG DER ABBILDUNGEN

Nachfolgend wird die Erfindung anhand einer vorteilhaften Ausführungsform rein beispielhaft unter Bezugnahme auf die beigefügten Zeichnungen beschrieben. Es zeigen:
Fig. 1 zeigt eine Schaltvorrichtung aus dem Stand der Technik.
Fig. 2 zeigt eine Ansicht auf die erste Oberfläche der Leiterplatte.
Fig. 3 zeigt eine Ansicht auf die erste Oberfläche der Leiterplatte mit angebrachten Kontaktstift.

### BESCHREIBUNG EINES AUSFÜHRUNGSBEISPIELS

Im Folgenden werden bevorzugte Ausgestaltungen der Erfindung näher beschrieben. Ähnliche oder korrespondierende Einzelheiten des erfindungsgemäßen Gegenstandes sind mit denselben Bezugszeichen versehen.

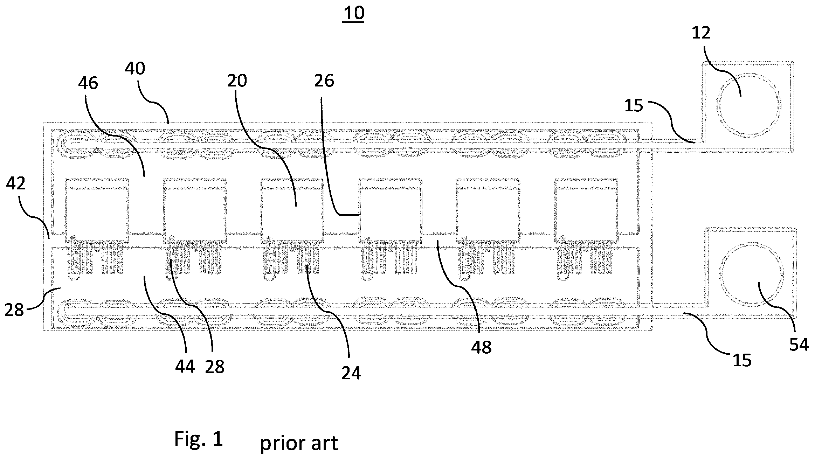

Figur 1 zeigt ein Schaltvorrichtung aus dem Stand der Technik in einer Draufsicht auf die Leiterplatte 40 einer Schaltvorrichtung 10 zum Schalten von elektrischen Strömen. Eine erste leitfähig beschichtete Fläche 44 und eine zweite leitfähig beschichtete Fläche 46, sind auf einer ersten Oberfläche 42 der Leiterplatte 40 angeordnet. Die erste leitfähig beschichtete Fläche 44 ist von einer nicht leitfähigen dritten Fläche 48 umrandet. Sechs Halbleiterbauelementen 20 sind auf der Leiterplatte angeordnet, wobei jedes Halbleiterbauelement 20 einen Körper 22, mit mindestens einem ersten Kontaktelement 24 und einem zweiten Kontaktelement 26 aufweist. Die ersten Kontaktelemente 24 sind mit der ersten leitfähig beschichteten Fläche 44 elektrisch verbunden und die zweiten Kontaktelemente 24 sind mit der zweiten leitfähig beschichteten Fläche 46 elektrisch verbunden. Die Halbleiterbauelemente 20 sind entlang der ersten leitfähig beschichteten Fläche 44 gleichmäßig verteilt, angeordnet. Jeweils eine Stromschiene 15 erstreckt sich entlang der ersten leitfähig beschichteten Fläche 44 und der zweiten leidlich beschichteten Fläche 46. Die Stromschienen 15 sind elektrisch und mechanisch mit den leitfähigen Flächen 44,46 verbunden. Jeweils an den Enden der Stromschienen 15 befinden sich Öffnungen 12,54 zum Durchführen von Kontaktstiften.

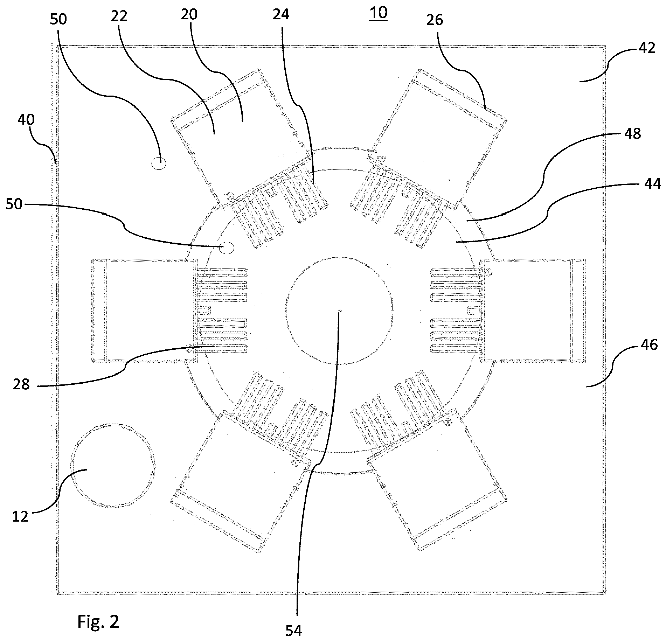

Figur 2 zeigt die erfinderische Schaltvorrichtung 10 zum Schalten von elektrischen Strömen. Die Leiterplatte 40 weit eine erste leitfähig beschichtete Fläche 44 und eine zweite leitfähig beschichtete Fläche 46 auf, angeordnet auf einer ersten Oberfläche 42 der Leiterplatte 40. Die erste leitfähig beschichtete Fläche 44 ist von einer nicht leitfähigen dritten Fläche 48 umrandet. Die dritte Fläche 48 ist von der zweiten leitfähig beschichteten Fläche 46 umgeben. Mindestens drei Halbleiterbauelementen 20 sind auf der Leiterplatte angeordnet, wobei jedes Halbleiterbauelement 20 einen Körper 22, mit mindestens einem ersten Kontaktelement 24 und einem zweiten Kontaktelement 26 aufweist. Die ersten Kontaktelemente 24 sind mit der ersten leitfähig beschichteten Fläche 44 elektrisch verbunden und die zweiten Kontaktelemente 26 sind mit der zweiten leitfähig beschichteten Fläche 46 elektrisch verbunden. Die Halbleiterbauelemente 20 sind entlang des Umfangs, der ersten leitfähig beschichteten Fläche 44 gleichmäßig verteilt, angeordnet. Die ersten leitfähig beschichteten Fläche 44 weist einen kreisförmigen Umfang auf. Die Halbleiterbauelemente 20 sind kreisförmig um die erste leitfähig beschichteten Fläche 44 angeordnet. Die Halbleiterbauelemente 20 sind gleichmäßig über den Umfang verteilt. Die Leiterplatte 40 weist im Zentrum der erste leitfähig beschichteten Fläche 44 eine Anschlussöffnung 54, zum Durchführen eines Kontaktstiftes 100 auf. Der Durchmesser der Anschlussöffnung 54 ist kleiner als der Durchmesser der erste leitfähig beschichteten Fläche 44. Die erste leitfähig beschichtete Fläche 44 ist wesentlich kleiner als die zweite leitfähig beschichtete Fläche 46. Die nicht leitfähige dritte Fläche 48 ist frei von leitfähiger Beschichtung. Die Leiterplatte 40 weist eine leitfähige Schicht auf, die zwischen den Oberflächen der Leiterplatte 40 verläuft. Die Halbleiterbauelemente 20 weisen ein drittes Kontaktelement 28 auf. Das dritte Kontaktelement ist elektrisch mit der, innerhalb der Leiterplatte 40, verlaufenden leitfähigen Schicht verbunden. Die Leiterplatte 40 weist im Bereich der zweiten leitfähig beschichteten Fläche 46 eine Öffnung 12, zum Durchführen eines Kontaktstiftes 100, auf. Das erste Kontaktelement 24 der Halbleiterbauelemente ist, als aus dem Körper 22 ragendes, Bein ausgeführt und die zweiten Kontaktelemente 26 der Halbleiterbauelemente werden durch eine leitende Fläche des Körpers gebildet. Sechs Halbleiterbauelementen 20 sind gleichmäßig, entlang des Umfangs der ersten leitfähig beschichteten Fläche 44, angeordnet. Die Leiterplatte 40 weist eine Vielzahl von leitfähigen Schichten auf, die innerhalb des Leiterplatten-Substrats verlaufen (nicht gezeigt). Ein Teil der Schichten ist mittels einer Vielzahl von Durchkontaktierungen 50 mit den anderen leitfähig beschichteten Flächen verbunden.

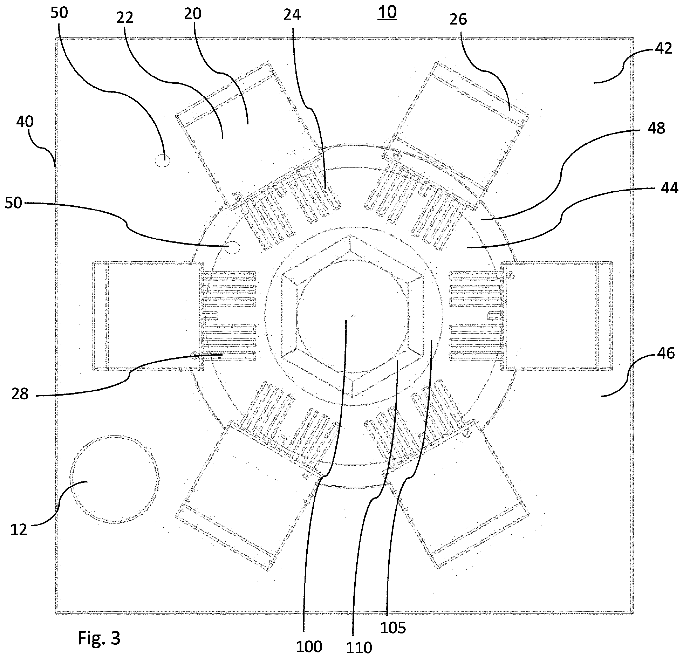

Figur 3 zeigt die Schaltvorrichtung 10 mit angebrachten Kontaktstift 100. Der Kontaktstift 100 ist in der Anschlussöffnung 54 positioniert. Eine Unterlegscheibe 105 ist in Kontakt mit der ersten leitfähig beschichteten Fläche 44. Eine Mutter 110 auf den Kontaktstift 100 aufgeschraubt, presst die Unterlegscheibe 105 gegen die erste leitfähig beschichteten Fläche 44 und kontaktiert elektrisch den Kontaktstift 100 mit der Schaltvorrichtung 10.

## Patentansprüche

1. Schaltvorrichtung (10) zum Schalten von elektrischen Strömen, umfassend eine Leiterplatte (40) aufweisend eine erste leitfähig beschichtete Fläche (44) und eine zweite leitfähig beschichtete Fläche (46), angeordnet auf einer ersten Oberfläche (42) der Leiterplatte (40), wobei die erste leitfähig beschichtete Fläche (44) von einer nicht leitfähigen dritten Fläche (48) umrandet ist und wobei die dritte Fläche (48) von der zweiten leitfähig beschichteten Fläche (46) umgeben ist, und mindestens drei Halbleiterbauelementen (20), wobei jedes Halbleiterbauelement (20) einen Körper (22), mit mindestens einem ersten Kontaktelement (24) und einem zweiten Kontaktelement (26) aufweist, wobei die Halbleiterelemente (20) auf der Leiterplatte angeordnet sind, und wobei die ersten Kontaktelemente (24) mit der ersten leitfähig beschichteten Fläche (44) elektrisch verbunden sind und wobei die zweiten Kontaktelemente (24) mit der zweiten leitfähig beschichteten Fläche (46) elektrisch verbunden sind, wobei die Halbleiterbauelemente (20) gleichmäßig verteilt, entlang des Umfangs, der ersten leitfähig beschichteten Fläche (44) angeordnet sind.

2. Schaltvorrichtung (10) nach Anspruch 1, wobei die erste leitfähig beschichtete Fläche (44) einen kreisförmigen Umfang aufweist und wobei die Halbleiterbauelemente (20) kreisförmig um die erste leitfähig beschichtete Fläche (44) angeordnet sind.

3. Schaltvorrichtung (10) nach dem vorhergehenden Anspruch, wobei die Leiterplatte (40) im Zentrum der ersten leitfähig beschichteten Fläche (44) eine Anschlussöffnung (54), zum Durchführen eines Kontaktstiftes (100) aufweist, wobei der Durchmesser der Anschlussöffnung (54) kleiner ist als der Durchmesser der ersten leitfähig beschichteten Fläche (44).

4. Schaltvorrichtung (10), nach einem der vorhergehenden Ansprüche, wobei die erste leitfähig beschichtete Fläche (44) wesentlich kleiner als die zweite leitfähig beschichtete Fläche (46) ist.

5. Schaltvorrichtung (10) nach einem der vorhergehenden Ansprüche, wobei die nicht leitfähige dritte Fläche (48) frei von leitfähiger Beschichtung ist.

6. Schaltvorrichtung (10) nach einem der vorhergehenden Ansprüche, wobei die Leiterplatte (40) eine innere leitfähige Schicht aufweist, die zwischen den Oberflächen der Leiterplatte (40) verläuft und wobei die Halbleiterbauelemente (20) ein drittes Kontaktelement (28) aufweisen, wobei das dritte Kontaktelement elektrisch mit der innerhalb verlaufenden leitfähigen Schicht verbunden ist.

7. Schaltvorrichtung (10) nach einem der vorhergehenden Ansprüche, wobei die Leiterplatte (40) im Bereich der zweiten leitfähig beschichteten Fläche (46) eine Öffnung (12), zum Durchführen eines Kontaktstiftes (100) aufweist.

8. Schaltvorrichtung (10) nach einem der vorhergehenden Ansprüche, wobei die Leiterplatte (40) eine Vielzahl von leitfähigen Schichten aufweist, die innerhalb des Leiterplatten-Substrats verlaufen, wobei ein erster Teil der Schichten mittels einer Vielzahl von Durchkontaktierungen (50) mit der erste leitfähig beschichtete Fläche (44) verbunden sind und wobei ein zweiter Teil der Schichten mittels einer Vielzahl von Durchkontaktierungen (50) mit der zweiten leitfähig beschichtete Fläche (46) verbunden sind.

9. Schaltvorrichtung (10) nach einem der vorhergehenden Ansprüche, wobei der Aufbau und die Bestückung der Leiterplatte (40) auf einer zweiten Oberfläche, gegenüber der ersten Oberfläche (42), identisch zur ersten Oberfläche (42) gestaltet ist.

10. Schaltvorrichtung (10) nach Anspruch 3 und 9, wobei die zweite leitfähig beschichtete Fläche auf der zweiten Oberfläche und die zweite leitfähig beschichteten Fläche (46) auf der ersten Oberfläche (42) in einem Winkel, in Bezug zur Anschlussöffnung (54), angeordnet sind.

11. Schaltvorrichtung (10) nach einem der vorhergehenden Ansprüche, wobei das ersten Kontaktelement (24) der Halbleiterbauelemente (20) als, aus dem Körper (22) ragendes Bein ausgeführt ist und wobei das zweiten Kontaktelement (26) der Halbleiterbauelemente (20), durch eine leitende Fläche des Körpers gebildet wird.

12. Schaltvorrichtung (10) nach einem der vorhergehenden Ansprüche, wobei sechs Halbleiterbauelementen (20) gleichmäßig, entlang des Umfangs der ersten leitfähig beschichteten Fläche (44), angeordnet sind.

13. Schaltmodul umfassend eine Vielzahl von Schaltvorrichtung (10) nach einem der vorhergehenden Ansprüche, wobei die Schaltvorrichtungen (10) durch Kontaktstifte (100) miteinander verbunden sind.

14. Fahrzeug mit einer Schaltvorrichtung (10) nach einem der vorhergehenden Ansprüche.
